# EUROPEAN PATENT APPLICATION

(11) **EP 1 313 136 A1**
(43) Date of publication of application: **21.05.2003**
(21) Application number: 02025046.0
(22) Date of filing: 11.11.2002
(51) Int. Cl.: H01L 21/312, H01L 21/60, H01L 23/485

(54) **Semiconductor device and method for manufacturing the same**

(30) Priority: 16.11.2001 JP 2001351656
(71) Applicant: SHINKO ELECTRIC INDUSTRIES CO. LTD., Nagano-shi, Nagano 380-0921 (JP)
(72) Inventor: Lijima, Takahiro, Shinko Electric Ind. Co, Ltd., Nagano-shi, Nagano 380-0921 (JP); Takano, Akihito, Shinko Electric Ind. Co, Ltd., Nagano-shi, Nagano 380-0921 (JP); Yamano, Takaharu, Shinko Electric Ind. Co, Ltd., Nagano-shi, Nagano 380-0921 (JP); Yoshihara, Takako, Shinko Electric Ind. Co, Ltd., Nagano-shi, Nagano 380-0921 (JP); Seki, Yoshikatsu, Shinko Electric Ind. Co, Ltd., Nagano-shi, Nagano 380-0921 (JP)
(74) Representative: Schmidt, Steffen J., Dipl.-Ing.

(57) **Abstract**

A semiconductor device comprises a semiconductor element having an electrode forming surface on which an electrode terminal is formed, an insulating layer made of phenol resin covering the electrode forming surface, and a rewiring pattern connected at one thereof to the electrode terminal and at the other end thereof to an external connecting terminal. During a process for manufacturing the phenol resin is cured at a temperature of 180°C to 200°C to form the insulating layer.

## Description

### BACKGROUND OF THE INVENTION

### 1. Field of the Invention

The present invention relates to a semiconductor device, and to a method for manufacturing the semiconductor device, in which a rewiring pattern to be electrically connected with electrode terminals is formed on an electrode terminal forming face of an semiconductor element and is connected with external connecting terminals.

### 2. Description of the Related Art

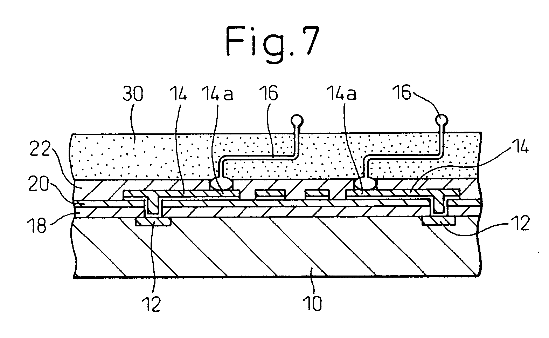

As a method for manufacturing a semiconductor device such as a chip-size package, there is provided a method in which a semiconductor wafer is used as a workpiece to manufacture the semiconductor device, a rewiring pattern is formed on an electrode terminal forming face of the semiconductor wafer, external connecting terminals are formed by being electrically connected with the rewiring pattern, and then the semiconductor wafer is divided into individual pieces so as to obtain individual semiconductor devices. Fig. 7 is a view showing an example of the semiconductor device manufactured by this method, i.e., a "wafer-level package manufacturing method". As shown in Fig. 7, this product is provided with external connecting terminals which are formed by bending a wire into an L-shape.

With reference to Fig. 7, there is shown an enlarged sectional view of the semiconductor device, reference numeral 10 is a semiconductor device, reference numeral 12 is an electrode terminal formed on an electrode terminal forming face of the semiconductor element 10, reference numeral 14 is a rewiring pattern electrically connected with the electrode terminal 12, and reference numeral 16 is an external connecting terminal. Reference numerals 18, 20, 22 are respectively a passivation film, insulating layer and an overcoat layer which are electrically insulating layers. The external connecting terminal 16 shown in the drawing, which is bent into an L-shape, can be formed in such a manner that a gold wire is bonded to the land 14a on the rewiring pattern 14 with a bonding tool, the thus bonded gold wire is bent into an L-shape by moving the bonding tool, and then an end portion of the gold wire is cut off while being melted.

In order to maintain the profile of the external connecting terminal 16, after the wire has been formed into an L-shape, plating is conducted on the wire in some cases. There are provided various conditions of the external connecting terminal to be formed being electrically connected with the rewiring pattern 14. The external connecting terminal, which is formed by bending a wire into an L-shape, is advantageous in that thermal stress, which is generated between a mounting substrate and semiconductor device when the semiconductor device is mounted in the substrate, can be effectively reduced by a buffer action of the terminal itself.

In the semiconductor device shown in Fig. 7 which is manufactured by using a semiconductor wafer as a workpiece, the passivation film 18, insulating layer 20 and overcoat layer 22 are provided for protecting the semiconductor wafer and for electrically insulating and protecting the rewiring pattern 14. However, it is conventional to use heat resistant resins, such as polyimide, when the above electrically insulating layers are formed. These heat resistant resins are used for the object of providing a sufficiently high heat resistance and durability.

Although these resin materials are highly heat-resistant and reliable, the following disadvantages are encountered. When these resin materials are cured by heating in the process of forming an electrically insulating layer, it is necessary to heat these resin materials to high temperatures of about 300°C. Therefore, thermal stress acts on a semiconductor device in the curing process, and the semiconductor device is damaged due to such thermal stress.

The adherence between the conventional insulating layer 20, which is composed of an electrically insulating layer such as polyimide, and the rewiring pattern 14 is not necessarily high. Therefore, the following problems may be encountered. When the semiconductor device is mounted on a substrate, the rewiring pattern 14 is peeled off from the insulating layer 20 by thermal stress (tensile force) acting on the external connecting terminal 16 and, further, cracks are caused on the insulating layer 20 or overcoat layer 22 by a change in the outside temperature, which causes a reduction in the electrically insulating function and also causes a reduction in the moisture resistance of the semiconductor device.

### SUMMARY OF THE INVENTION

The present invention has been accomplished to solve the above problems.

It is an object of the present invention to provide a semiconductor device, and a method for manufacturing the semiconductor device, having the following advantages. That is to say, if the thermal stress acting on a semiconductor wafer in the manufacturing process can be reduced, the influence of thermal stress acting on the semiconductor device can also be suppressed. In addition, the adherence property of an insulating layer and overcoat layer with a rewiring pattern is enhanced, so that the semiconductor device can resist a sudden change in temperature and the reliability can be enhanced.

According to the present invention, there is provided semiconductor device comprising: a semiconductor element having an electrode forming surface on which an electrode terminal is formed; an insulating layer covering the electrode forming surface of the semiconductor element, the insulating layer being made of phenol resin; and a rewiring pattern connected at one thereof to the electrode terminal and at the other end thereof to an external connecting terminal.

The semiconductor device further comprises an overcoat layer for covering the rewiring pattern and the insulating layer, the overcoat layer being made of phenol resin.

The semiconductor device further comprises a passivation film for covering the electrode forming surface, the passivation film being made of phenol resin.

The rewiring pattern is provided at the other end thereof with a land and the external connecting terminal, a wire bent in L-shape, is connected to the land of the rewiring pattern by wire-bonding.

According to another aspect of the present invention there is provided a process for manufacturing a semiconductor device comprising the following steps of: preparing a semiconductor element having an electrode forming surface on which an electrode terminal is formed; covering the electrode forming surface of the semiconductor element with a phenol resin so that the electrode is exposed therefrom; curing the phenol resin at a temperature of 180°C to 200°C to form an insulating layer; and forming a rewiring pattern on the insulating layer in such a manner that at least a part of the rewiring pattern is connected to the electrode terminal.

The process further comprises the following steps of: after the rewiring pattern is formed, covering again the insulating layer including the rewiring pattern with a phenol resin, so that a land part of the rewiring pattern on the insulating layer is exposed from the formed at the other end of the formed on the electrode is exposed phenol resin; and curing again the phenol resin at a temperature of 180°C to 200°C to form an overcoat layer for covering said insulating layer including the rewiring pattern.

The process further comprises the following steps of: wire-bonding a wire so as to connect, at one end thereof, to the land part of the rewiring pattern and then to bend the wire to form an L-shaped external terminal of the wire.

The process further comprises the following steps of: before the insulating layer is formed, covering the electrode forming surface with a phenol resin to be a passivation film; and curing the phenol resin at a temperature of 180°C to 200°C to form the passivation film so that the electrode terminal is exposed from the passivation film.

### BRIEF DESCRIPTION OF THE DRAWINGS

Figs. 1(a) to 1(f) are schematic illustrations showing a method of manufacturing a semiconductor device of the present invention;
Fig. 2 is a schematic illustration shoving a modified method similar to that shown in Figs. 1(a) to 1(f);
Fig. 3 is a schematic illustration showing another embodiment of a method of manufacturing a semiconductor device of the present invention;
Fig. 4 is a schematic illustration showing a modified method similar to that shown in Fig. 3;
Fig. 5 is a graph showing a result of a tensile test conducted on a rewiring pattern with respect to polyimide resin;
Fig. 6 is a graph showing a result of a tensile test conducted on a rewiring pattern with respect to phenol resin; and
Fig. 7 is a sectional view showing a composition of a conventional semiconductor device.

### DETAILED DESCRIPTION OF THE PREFERRED EMBODIMENTS

Referring to the accompanying drawings, preferred embodiments of the present invention will be explained as follows.

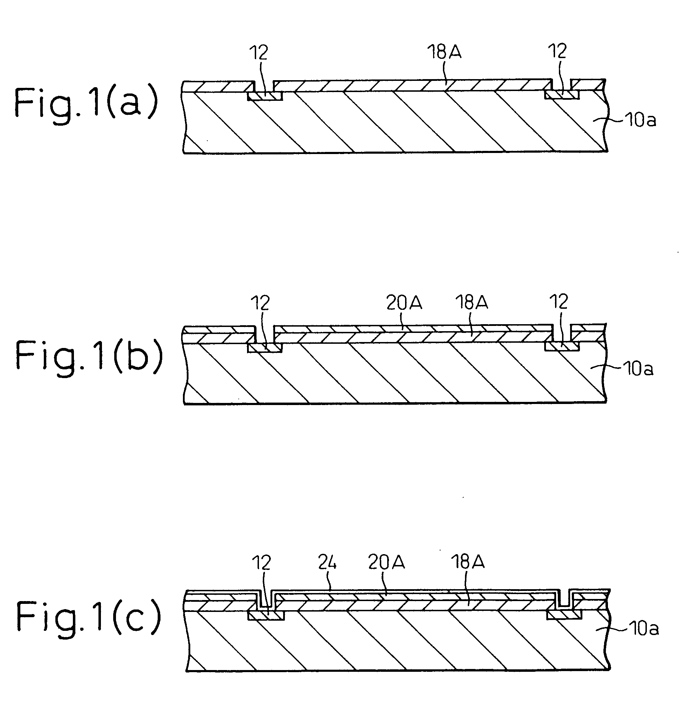

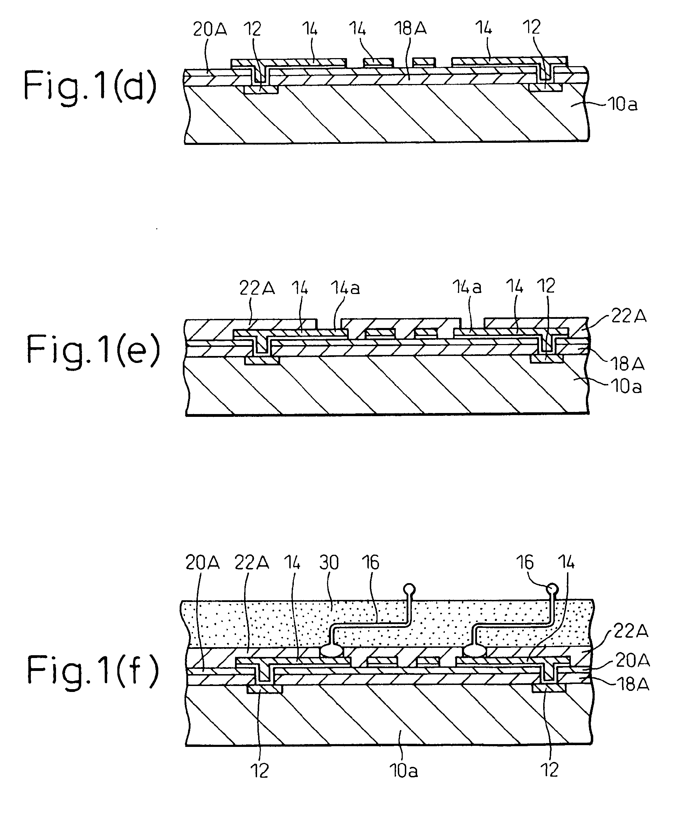

Fig. 1 is a view showing a method of manufacturing a semiconductor device, wherein a semiconductor wafer is used as a workpiece in this method.

Fig. 1(a) is an enlarged sectional view showing a semiconductor wafer 10a. Reference numeral 12 is an electrode terminal composed of an aluminum pad formed on an electrode terminal forming face of the semiconductor wafer 10a. Reference numeral 18A is a passivation film protecting the electrode terminal forming face of the semiconductor wafer 10a. The passivation film 18A covers the whole surface, except that the electrode terminal 12 is exposed from the passivation film. In general, the passivation film 18A is made of polyimide resin. However, when the passivation film 18A is made of phenol resin capable of being cured at a temperature lower than that of polyimide, thermal stress acting on the semiconductor device can be preferably reduced.

Usually, in the manufacturing process of a semiconductor device, the semiconductor wafer 10a is previously coated with the passivation film 18A.

Fig. 1(b) is a view showing a state in which the insulating layer 20A is formed on the passivation film 18A on a surface of the semiconductor wafer 10a. This insulating layer 20A protects the passivation film 18A (and the surface portion of the semiconductor device such as Al pad fuse which are not covered with the passivation film 18A.) and becomes a base on which the rewiring pattern 14 is formed.

The insulating layer 20A is formed as follows. In the state shown in Fig. 1(a), a resin material having an electrical insulating property is coated on a surface of the semiconductor wafer 10a and irradiated with laser light (or developed after exposed by a light source), so that a surface of the electrode terminal 12 is exposed and, then, the semiconductor wafer 10a is put into a heating furnace and cured so as to harden the insulating layer 20A. In this connection, in the case where resin material is coated and the surface of the electrode terminal 12 is exposed, when non-photosensitive resin is used, the surface of the electrode terminal 12 is exposed by irradiating laser beams, however, when photosensitive resin is used, the surface of the electrode terminal 12 can be exposed from the insulating layer 20A by light exposure and development.

It is conventional that polyimide resin is used for forming this insulating layer 20a. However, in the manufacturing method of this embodiment, phenol resin is used for forming this insulating layer 20a, which is the characteristic of the present invention.

The reason why phenol resin is used for forming the insulating layer 20A is described as follows. The curing temperature of phenol resin is about 180°C to 200°C, which is much lower than the curing temperature 270°C to 300°C of polyimide resin. Accordingly, it is possible to reduce thermal stress acting on the semiconductor device in the curing and hardening process of the insulating layer 20A. Due to the foregoing, it is possible to prevent the semiconductor device from being damaged.

Phenol resin is advantageous in that the adherence property of phenol resin with the rewiring pattern 14 formed on its surface is more excellent than that of polyimide resin and it is difficult for the rewiring pattern 14 formed on its surface to be peeled off from the insulating layer 20A. Further, phenol resin is advantageous as follows. As phenol resin is physically softer than polyimide resin, even when a sudden change in the temperature is caused on the insulating layer 20A, it is possible for phenol resin to absorb thermal stress. Therefore, it is possible to prevent the occurrence of cracks on the insulating layer 20A. When the rupture strength of polyimide resin is compared with the rupture strength of phenol resin, the rupture strength of polyimide resin is about 140 MPa, and the rupture strength of phenol resin is about 75 MPa. This fact shows that phenol resin is physically softer than polyimide resin.

Fig. 1(c) is a view showing a state in which the plating seed layer 24 is formed on a surface of the insulating layer 20A. This process is conducted before the rewiring pattern 14 is formed on the surface of the insulating layer 20A. The plating seed layer 24 becomes a layer to supply electricity for plating when electrolytic plating is conducted. The plating seed layer 24 is formed by means of sputtering or electroless plating.

Fig. 1(d) is a view showing a state in which electrolytic plating is conducted while the plating seed layer 24 is being used as a layer to supply electricity for plating, and the rewiring pattern 14 is formed on the surface of the insulating layer 20A. In this connection, concerning electrolytic plating, electrolytic gold plating is adopted.

The rewiring pattern 14 is formed as follows. First, in the state shown in Fig. 1(c), a photosensitive resist film is coated or laminated on the surface of the plating seed layer 24. Then, the photosensitive resist is exposed to light and developed, so that a resist pattern, which covers a portion except for a portion to become the rewiring pattern 14, is formed. Then, electrolytic plating is conducted while the resist pattern is being used as a mask.

When electrolytic pattern is formed, a portion to become the rewiring pattern 14 (the exposed portion on the surface of the plating seed layer 24) is formed so that the plating portion made of a metal, such as gold or copper, can rise. In this portion, a conductor to become the rewiring pattern 14 is formed according to the resist pattern. Next, when the resist pattern is melted and removed, the conductor section of the rewiring pattern 14 is exposed, and the plating seed layer 24 which has been covered with the resist pattern is also exposed. When the seed layer 24 exposed onto the surface is removed with an etching solution in the above state, the rewiring pattern 14 can be formed on the surface of the insulating layer 20A. The thickness (approximately, 0.3 µm) of the plating seed layer 24 is much smaller than the thickness (approximately, more than 3 µm) of the conductor portion of the rewiring pattern 14 which is formed by swelling the electrolytic plating portion. Therefore, it is unnecessary to cover the portion to become the rewiring pattern 14 with a protective film. When etching is conducted, only the seed layer 24 can be selectively removed.

The rewiring pattern 14 is formed so that it can be electrically connected with the electrode terminal 12 formed on the surface of the semiconductor wafer 10a. Therefore, when the photosensitive resist is exposed to light and developed so as to form the resist pattern, it is necessary to form a pattern so that the electrode terminal 12 and the rewiring pattern 14 can be electrically connected with each other. According to the method of manufacturing the semiconductor device of the present invention, one end side of the rewiring pattern 14 is electrically connected with the electrode terminal 12, and the other end side is connected with the land 14a to which the external connecting terminal 16 is joined. The reason why the rewiring pattern 14 is drawn out from the electrode terminal 12 is described as follows. When an entire face of the electrode terminal forming face of the semiconductor wafer 10a is utilized as a region in which the external connecting terminals are arranged, the external connecting terminals 16 can be easily arranged by drawing out the rewiring pattern 14 from the electrode terminal 12.

Fig. 1(e) is a view showing a state in which the surface, on which the rewiring pattern 14 is formed, is covered with the overcoat layer 22A. This embodiment is characterized in that this overcoat layer 22A is made of phenol resin instead of polyimide resin. In the same manner as that of the insulating layer 20A, the overcoat layer 22A is formed as follows. After a surface of the semiconductor wafer 10a, on which the rewiring pattern 14 has already been formed, is covered with phenol resin, laser light is irradiated onto it. Alternatively, when the resin is photosensitive, the land 14a of the rewiring pattern 14 is exposed to light and developed. Then, the workpiece is put into a heating furnace to be cured. In this way, the overcoat layer 22A is hardened. In this curing process, as the overcoat layer 22A is made of phenol resin in this embodiment, curing can be accomplished in the heating furnace in which temperatures are kept in a range from 180°C to 200°C. Therefore, thermal stress acting on the semiconductor device can be reduced.

Fig. 1(f) is a view showing a state in which the external connecting terminal 16 is formed in the land 14a of the rewiring pattern 14. In this connection, when the external connecting terminal 16 is joined to the land 14a, gold plating may be previously conducted on a surface of the land 14a. In this embodiment, there is provided an external connecting terminal 16 which is bent into an L-shape. This external connecting terminal 16 can be formed in such a manner that after the gold wire is bonded to the land 14a with a bonding tool, the bonding tool is moved in the lateral direction and then moved in the longitudinal direction. Finally, when the gold wire is cut off, an end portion of the gold wire is melted. Due to the foregoing, an end portion of the external connecting terminal can be formed into a small sphere.

After the L-shaped connecting terminal 16 is formed as mentioned above, an encapsulated resin 30 is formed to cover the overcoat layer 22A to protect the same as well as the L-shaped connecting terminal 16. The upper end of the respective the L shaped connecting terminal 16 extends outward from the upper surface of the encapsulated resin 30.

In this way, after the external connecting terminals 16 have been formed on the entire face of the electrode terminal forming face of the semiconductor wafer 10a and the encapsulated resin 30 is formed, the semiconductor wafer 10a is diced into individual pieces, and the individual semiconductor devices can be provided.

In this connection, in the above embodiment, after the overcoat layer 22A has been previously formed on a surface of the insulating layer 20A on which the rewiring pattern 14 is formed, the external connecting terminal 16 is formed. However, it is possible to adopt a process conducted in such a manner that after the rewiring pattern 14 has been formed and the external connecting terminal 16 has been joined to the land 14a, the overcoat layer 22A is formed. In this case, after the external connecting terminal 16 has been formed, liquid resin of phenol is subjected to spin-coating so that a surface of the semiconductor wafer 10a can be coated with liquid resin of phenol.

In the semiconductor device obtained by the above method, the insulating layer 20A covering the electrode terminal forming face of the semiconductor element 10 and the overcoat layer 22A are made of phenol resin. Therefore, compared with a conventional product in which the insulating layer 20 and the overcoat layer 22A are made of polyimide resin, the adherence property of the rewiring pattern 14 with the insulating layer 20A and the overcoat layer 22A can be enhanced. Further, the durability with respect to a change in the external temperature can be enhanced. Accordingly, it is possible to provide a product which is more reliable than a conventional product.

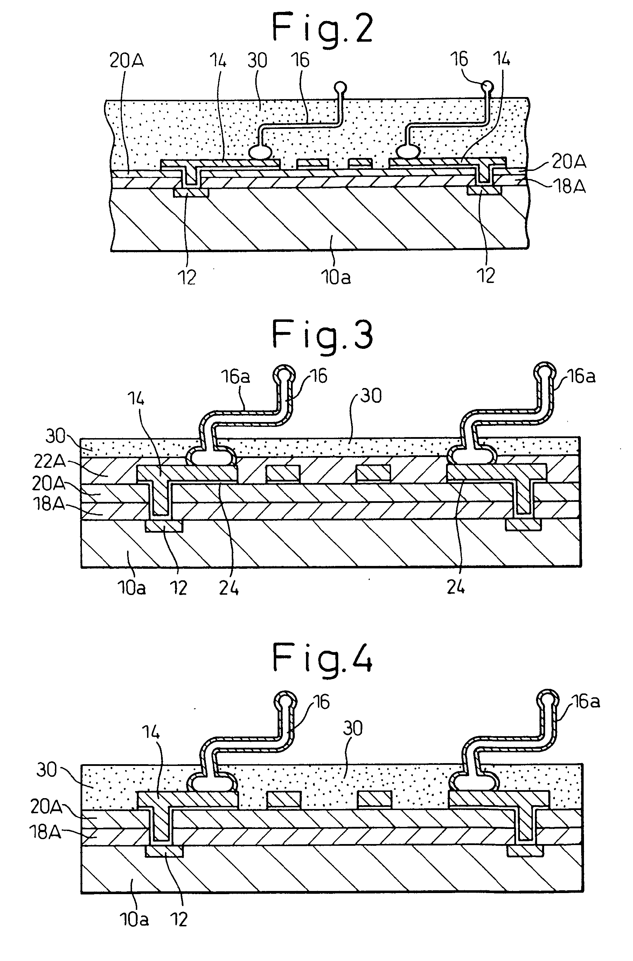

Fig. 2 is a schematic illustration showing a modified method similar to that shown in Figs. 1(a) to 1(f). In this modified method, however, the overcoat layer 22A is not formed. Consequently, after the process shown in Fig. 1(d), the process shown in Fig. 1(f) is conducted, i.e., forming L-shaped connecting terminals 16 and then forming the encapsulated layer 30, as described in connection with Fig. 1(f).

Fig. 3 is a schematic illustration showing another embodiment of a method of manufacturing a semiconductor device of the present invention. In this embodiment, the processes until the plating seed layer 24 is formed are the same as the previous embodiment shown in Figs. 1(a) to 1(c). In the process shown in Fig. 1(d), in this embodiment, after the rewiring pattern 14 is formed, the plating seed layer 24 is not etched, but it will be etched at a later stage.

Next, before the L-shaped connecting terminals 16 are formed, a bonding resist is provided for the wire-bonding process. In addition, in this embodiment, after having formed with the L-shaped connecting terminals 16 by a wire-bonding process, they are plated with nickel alloy layer 16a. During this nickel-alloy plating process the seed layer 24, which has not yet been etched, can be used as a power supply layer.

Then, the bonding resist is removed and also the plating seed layer 24, except for the portion on which the rewiring patterns 14 are formed, is removed by etching.

Then, the overcoat layer 22A is formed and, then, the encapsulated resin 30 are also formed in the same manner as the first embodiment.

Fig. 4 is a schematic illustration showing a modified method similar to that shown in Fig. 3. Although in the embodiment shown in Fig. 3 the overcoat layer 22A is formed, in this modified method, however, the process of forming the overcoat layer 22A is omitted in the same manner as the modified embodiment of Fig. 2. Particularly, if the rewiring pattern 14 is formed of such a metal that is not easily corroded, such as gold (Au), the overcoat layer 22A can be omitted as shown in Fig. 2 or 4.

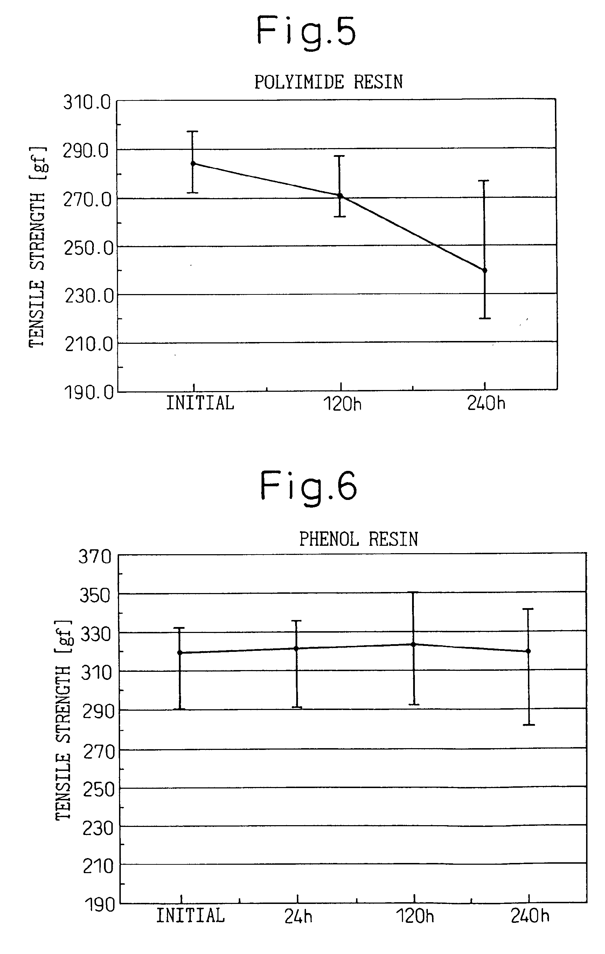

Figs. 5 and 6 are graphs showing a result of a test for testing a difference in the characteristic between phenol resin and polyimide resin. In this test, the shearing strength of the rewiring pattern with respect to each resin was tested. In this shearing strength test, the tensile strength of the rewiring pattern was measured in the case of a humidity resistance evaluation test.

Fig. 5 is a graph showing a result of a test for testing a sample in which the rewiring pattern was formed on the insulating layer made of polyimide resin. Fig. 6 is a graph showing a result of a test for testing a sample in which the rewiring pattern was formed on the insulating layer made of phenol resin. In the graph, the vertical line passing through each sample shows a range of dispersion of the sample, and the average values of the samples are connected with each other by straight lines.

The following can be understood from the graphs shown in Figs. 5 and 6. The tensile strength of polyimide resin is gradually lowered in accordance with the lapse of time. On the other hand, the tensile strength of phenol resin substantially stays at the initial value although the dispersion of the tensile strength is a little increased in accordance with a lapse of time. That is, in the case where the insulating layer is made of phenol resin, the adherence property of the rewiring pattern with the insulating layer is enhanced. Therefore, even when an external force such as thermal stress is given to the external connecting terminal, the rewiring pattern is not peeled off and the reliability of the semiconductor device can be enhanced.

In the case of the semiconductor device having the L-shaped external connecting terminal 16 shown in Fig. 1(f), the buffer property of the external connecting terminal can be enhanced and further the peeling strength of the rewiring pattern 14 can be enhanced. Therefore, the reliability of the semiconductor device can be further enhanced. The adherence of phenol resin to the semiconductor element is so high that cracks are seldom caused even when the external temperature changes and, further, the moisture resistance property is excellent. Therefore, the reliability can be further enhanced.

In this connection, when the insulating layer 20A and the overcoat layer 22A are made of phenol resin in the case of forming a semiconductor device, it is possible to provide the above operation and effect. Further, when the passivation film 18A formed on a surface of the semiconductor wafer is made of phenol resin, it becomes possible to prevent extremely high thermal stress from acting on the semiconductor device in the process of manufacturing the semiconductor, which is effective for enhancing the reliability of the semiconductor device.

In this connection, in the above embodiment, explanations are made into a semiconductor device having an external connecting terminal which is formed in such a manner that a wire is bent into an L-shape. However, it should be noted that the semiconductor device, in which an insulating layer is provided on an electrode terminal forming face of a semiconductor wafer so as to form an external connecting terminal, is not limited to the above specific embodiment. For example, in the case of a semiconductor device in which an external connecting terminal is formed by swelling a conductor in a connecting hole formed on an insulating layer so that the conductor can be formed into a columnar shape, when the insulating layer is made of phenol resin, the same operation and effect can be provided. Due to the foregoing, the reliability of the semiconductor device can be enhanced.

According to the semiconductor device of the present invention, when the insulating layer and the overcoat layer forming the rewiring pattern are made of phenol resin, the adherence of the rewiring pattern to the electrical insulating layer can be enhanced, and the moisture resistance can be also enhanced. Therefore, it becomes possible to provide a highly reliable semiconductor device. According to the method of manufacturing a semiconductor device of the present invention, it is possible to manufacture a semiconductor device without applying extremely high thermal stress to the semiconductor device. Therefore, it becomes possible to provide a highly reliable semiconductor device.

It will be understood by those skilled in the art that the foregoing description relates to only a preferred embodiment of the disclosed invention, and that various changes and modifications may be made to the invention without departing the sprit and scope thereof.

## Claims

1. A semiconductor device comprising:
a semiconductor element having an electrode forming surface on which an electrode terminal is formed;
an insulating layer covering the electrode forming surface of the semiconductor element, the insulating layer being made of phenol resin; and
a rewiring pattern connected at one thereof to the electrode terminal and at the other end thereof to an external connecting terminal.

2. A semiconductor device as set forth in claim 1, further comprising:
an overcoat layer for covering said rewiring pattern and said insulating layer, said overcoat layer being made of phenol resin.

3. A semiconductor device as set forth in claim 1, further comprising:
a passivation film for covering said electrode forming surface, said passivation film being made of phenol resin.

4. A semiconductor device as set forth in claim 1, wherein said rewiring pattern is provided at the other end thereof with a land and said external connecting terminal is a wire, bent in L-shape, which is connected to said land of the rewiring pattern by wire-bonding.

5. A process for manufacturing a semiconductor device comprising the following steps of:
preparing a semiconductor element having an electrode forming surface on which an electrode terminal is formed;
covering said electrode forming surface of the semiconductor element with a phenol resin so that said electrode is exposed therefrom;
curing said phenol resin at a temperature of 180°C to 200°C to form an insulating layer; and
forming a rewiring pattern on said insulating layer in such a manner that at least a part of said rewiring pattern is connected to said electrode terminal.

6. A process as set forth in claim 5, further comprising the following steps of:
after said rewiring pattern is formed, covering again said insulating layer including said rewiring pattern with a phenol resin, so that a land part of said rewiring pattern on said insulating layer is exposed from said the formed at the other end of the formed on the said electrode is exposed phenol resin; and
curing again said phenol resin at a temperature of 180°C to 200°C to form an overcoat layer for covering said insulating layer including said rewiring pattern.

7. A process as set forth in claim 6, further comprising the following step of:
wire-bonding a wire so as to connect one end thereof to said land part of said rewiring pattern and then to bend said wire to form an L-shaped external terminal of said wire.

8. A process as set forth in claim 5, further comprising the following steps of:
before said insulating layer is formed, covering said electrode forming surface with a phenol resin to be a passivation film; and
curing said phenol resin at a temperature of 180°C to 200°C to form said passivation film so that said electrode terminal is exposed from said passivation film.
